# FASCICULE DE BREVET EUROPEEN

(11) **EP 3 884 238 B1**
(45) Date de publication et mention de la délivrance du brevet: **27.12.2023**
(21) Numéro de dépôt: 19806208.5
(22) Date de dépôt: 20.11.2019
(51) Int. Cl.: G01C 21/16

(54) **DISPOSITIF DE MESURE INERTIELLE**
TRÄGHEITSMESSVORRICHTUNG
INERTIAL MEASUREMENT DEVICE

(30) Priorité: 20.11.2018 FR 1871622
(43) Date de publication de la demande: 29.09.2021
(73) Titulaire: Safran Electronics & Defense, 75015 Paris (FR)
(72) Inventeur: LIGNON, Christian, 77550 MOISSY- CRAMAYEL (FR); ELIE, Philippe, 77550 MOISSY - CRAMAYEL (FR); FAURE, Sylvain, 77550 MOISSY - CRAMAYEL (FR)
(74) Mandataire: Lavialle, Bruno François Stéphane
(86) Numéro de dépôt international: PCT/EP2019/081891
(87) Numéro de publication internationale: WO 2020/104507

(56) Documents cités:
- EP-A2- 2 239 539
- WO-A1-2014/102261
- US-A1- 2016 223 357

## Description

La présente invention concerne le domaine de la mesure inertielle et plus particulièrement un dispositif de mesure inertielle destiné à être embarqué dans un véhicule porteur pour déterminer les mouvements de ce véhicule. Le véhicule peut être un véhicule terrestre, aérien, ou nautique, de tout type.

### ARRIERE-PLAN TECHNOLOGIQUE

Les capteurs inertiels les plus connus sont les accéléromètres pour mesurer des grandeurs vectorielles et les gyromètres pour mesurer des grandeurs angulaires. Les gyromètres les plus couramment employés sont les gyromètres à masses mobiles, notamment sous forme de systèmes microélectromécaniques.

Une unité de mesure inertielle comprend généralement trois gyromètres et trois accéléromètres disposés selon les axes d'un repère de mesure. Les accéléromètres mesurent les composantes d'un vecteur de la force spécifique tandis que les gyromètres déterminent l'orientation de ce vecteur dans le repère inertiel. Le calcul de la différence entre le vecteur de force spécifique et le champ de gravité fournit l'accélération qui sera par la suite intégrée pour fournir les données de navigation.

On sait qu'une unité de mesure inertielle fournit des mesures affectées par des erreurs, telles que les biais accélérométriques, les dérives gyroscopiques et les angles de calage, produisant une imprécision dans la détermination de la verticale.

Il est connu de monter l'unité de mesure inertielle sur un plateau entraîné en rotation autour d'un axe sensiblement vertical par un moteur relié à l'unité électronique pour être commandé par celle-ci de manière à amener l'unité de mesure inertielle dans plusieurs positions sur un tour complet. En exploitant les mesures de l'unité de mesure dans ces différentes positions, on obtient un moyennage des erreurs en appliquant un filtrage passe-bas qui permet d'améliorer la précision de la détermination de la verticale.

Cependant, on s'est aperçu que lorsqu'un gyromètre est entraîné en rotation autour d'un axe sensiblement décalé par rapport à l'axe sensible du gyromètre, le gyromètre présente une erreur supplémentaire qui conduit à un saut angulaire aléatoire pendant le mouvement du gyromètre. A long terme, l'accumulation des sauts aléatoires est équivalent à un défaut de type « random walk » ayant une composante très basse fréquence. Ce type de défaut n'est pas moyenné par un filtrage passe-bas et affecte donc la précision des mesures.

Le document n°EP-A-2239539 décrit ainsi un procédé pour améliorer la précision et la stabilité d'une unité de mesure inertielle en faisant tourner celle-ci.

### OBJET DE L'INVENTION

Un but de l'invention est d'améliorer la précision des dispositifs inertiels.

### BREF EXPOSE DE L'INVENTION

A cet effet, on prévoit, selon l'invention un dispositif de mesure inertielle agencé pour être embarqué dans un véhicule porteur, comprenant : un bâti, un plateau monté sur le bâti pour tourner autour d'un axe de rotation (Z) normal à une surface du plateau, et une première unité de mesure inertielle qui est montée sur ladite surface du plateau et qui est reliée à une unité électronique de commande reliée à un moteur d'entraînement en rotation du plateau pour commander la rotation du plateau, la première unité de mesure inertielle comprenant trois gyromètres (20x, 20y, 20z) et trois accéléromètres (10x, 10y, 10z) disposés selon les axes d'un premier repère de mesure (R1) ; caractérisé en ce qu'il comprend une deuxième unité de mesure inertielle, solidaire du bâti, comprenant trois gyromètres et trois accéléromètres disposés selon les axes d'un deuxième repère de mesure (R2), et en ce que l'unité de commande est agencée pour :
- depuis une position angulaire initiale fixe du plateau, faire périodiquement tourner le plateau sur un tour avec un mouvement aller et un mouvement retour symétrique pour ramener le plateau dans la position initiale fixe,
- calculer, sur une durée prédéterminée, une accélération du véhicule porteur à partir :
   . des mesures accélérométriques et des mesures gyrométriques de la première unité de mesure inertielle tant que le plateau est fixe,
   . des mesures accélérométriques et des mesures gyrométriques de la deuxième unité de mesure inertielle tant que le plateau est en mouvement,
- reconstituer un repère inertiel de chaque unité de mesure inertielle à partir des mesures accélérométriques et des mesures gyrométriques mesurées par ladite unité de mesure pendant la durée prédéterminée et comparer les deux repères inertiels pour déterminer un écart d'orientation entre eux et tenir compte de cet écart d'orientation dans le calcul de l'accélération lors du passage de l'utilisation des mesures gyrométriques de la première unité de mesure à l'utilisation des mesures gyrométriques de la deuxième unité de mesure et inversement.

Ainsi, le calcul de l'accélération n'est pas affecté par le défaut mentionné ci-dessus puisque ce sont les mesures de la deuxième unité de mesure inertielle, fixe, qui vont être utilisée pendant que la première unité de mesure inertielle est en mouvement. En outre, la prise en compte de l'écart entre les repères inertiels des deux unités de mesure inertielle permet d'assurer une continuité de l'information angulaire, au moins pour ce qui concerne le plan normal au vecteur force spécifique, lors du passage de l'utilisation des mesures de l'une des unités de mesure inertielle à celle de l'autre des unités de mesure inertielle.

On rappelle ici que pour chaque unité de mesure inertielle, les trois accéléromètres mesurent les trois composantes du vecteur force spécifique. Les « mesures accélérométriques » de chaque centrale inertielle correspondent donc aux trois composantes dudit vecteur force spécifique.

D'autres caractéristiques et avantages de l'invention ressortiront à la lecture de la description qui suit d'un mode de réalisation particulier et non limitatif de l'invention.

### BREVE DESCRIPTION DES DESSINS

Il sera fait référence aux dessins annexés, parmi lesquels :

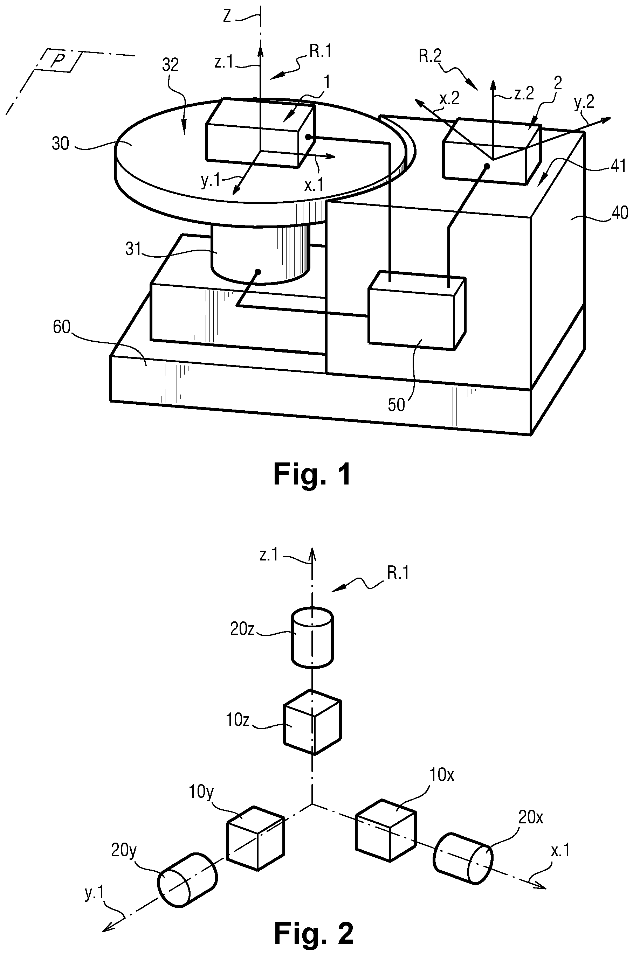

[Fig.1] la figure 1 est une vue schématique en perspective d'un dispositif selon un premier mode de réalisation de l'invention ;

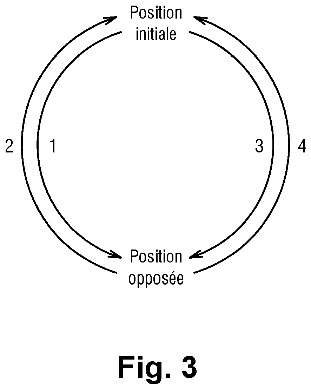

[Fig.2] la figure 2 est une vue schématique en perspective d'une des unités de mesure inertielles de ce dispositif ; [Fig.3] la figure 3 illustre le déplacement d'un point périphérique du plateau pendant le mouvement de celui-ci.

### DESCRIPTION DETAILLEE DE L'INVENTION

En référence aux figures, le dispositif selon l'invention, destiné à être fixé dans un véhicule porteur, comprend deux unités de mesure inertielle, généralement désignées en 1, 2, comprenant chacune trois accéléromètres 10x, 10y, 10z, et trois gyromètres 20x, 20y, 20z, qui sont disposés selon les axes x.1, y.1, z.1, x.2, y.2, z.2, d'un repère R.1, R.2. Les unités de mesure inertielle 1, 2 sont connues en elles-mêmes. En particulier, les accéléromètres et les gyromètres sont ici de type MEMS et sont connus en eux-mêmes.

L'unité de mesure inertielle 1 est fixée sur un plateau 30 monté sur un bâti 40 pour pivoter autour d'un axe Z qui s'étend ici verticalement et est normal à une surface supérieure 32 du plateau 30 portant l'unité de mesure inertielle 1 et à une surface supérieure 41 du bâti 40. L'axe Z.1 de l'unité de mesure inertielle 1 est colinéaire à l'axe Z.

Le plateau 30 est entraîné en rotation autour de l'axe Z par un moteur 31 connu en lui-même. Le moteur 31 est monté sur un stabilisateur 60, connu en lui-même, agencé pour maintenir la surface supérieure du plateau 30 sensiblement à l'horizontale en autorisant un débattement angulaire du véhicule porteur d'environ 20 degrés par rapport au plan horizontal. Le moteur 31 est ici à pilotage direct, mais pourrait être également du type servomoteur.

L'unité de mesure inertielle 2 est fixée sur la surface supérieure 41 du bâti 40. La surface supérieure 41 et la surface supérieure 32 du plateau 30 s'étendent dans un même plan P. Ainsi, la centrale inertielle 1 et la deuxième centrale inertielle 2 sont positionnées sur un même plan P perpendiculaire à l'axe de rotation Z.

Les unités de mesure inertielle 1, 2 et le moteur 31 sont électriquement reliés à une unité de commande 50. L'unité de commande 50 comprend un circuit électronique comportant un processeur et des mémoires pour exécuter un programme informatique de positionnement comprenant des instructions agencées pour traiter des signaux provenant des unités de mesure inertielle 1, 2 pour fournir une attitude du véhicule porteur et une accélération de celui-ci .

Selon l'invention, l'unité de commande 50 est programmée pour :
- depuis une position angulaire initiale fixe du plateau 30, faire périodiquement tourner le plateau 30 sur un tour avec un mouvement aller et un mouvement retour symétrique pour ramener le plateau 30 dans la position initiale fixe,
- calculer, sur une durée prédéterminée, une accélération du véhicule porteur à partir :
   . des mesures accélérométriques et des mesures gyrométriques de la première unité de mesure inertielle 1 tant que le plateau 30 est fixe,
   . des mesures accélérométriques et des mesures gyrométriques de la deuxième unité de mesure inertielle 2 tant que le plateau 30 est en mouvement,
- reconstituer un repère inertiel de chaque unité de mesure inertielle à partir des mesures accélérométriques et des mesures gyrométriques mesurées par ladite unité de mesure inertielle pendant la durée prédéterminée et comparer les deux repères inertiels pour déterminer un écart apparaissant entre eux au moment de la rotation du plateau 30 et tenir compte de cet écart dans le calcul de l'accélération lors du passage de l'utilisation des mesures gyrométriques de la première unité de mesure 1 à l'utilisation des mesures gyrométriques de la deuxième unité de mesure 2 et inversement.

L'unité de commande 50 est agencée pour commander le moteur 31 de telle manière que le mouvement aller et le mouvement retour comprennent un arrêt en une position angulaire intermédiaire prédéfinie. Le moteur 31 déplace le plateau 30 comme suit :
1. rotation de + 180° pendant un temps de déplacement t1 et arrêt pendant un temps d'arrêt t2,
2. rotation de - 180° pendant le temps de déplacement t1 et arrêt pendant le temps d'arrêt t2,
3. rotation de - 180° pendant le temps de déplacement t1 et arrêt pendant le temps d'arrêt t2,
4. rotation de + 180° pendant le temps de déplacement t1 et arrêt pendant le temps d'arrêt t2,
5. et ainsi de suite.

Pour un temps t d'une minute au tour aller-retour, on prévoira par exemple un temps t1 de 4 secondes et un temps t2 de 11 secondes.

Le principe de la comparaison des repères inertiels des deux unités de mesure inertielle consiste à les orienter l'un par rapport à l'autre en utilisant comme référence le vecteur de force spécifique puis en effectuant une projection dans un plan perpendiculaire au vecteur de force spécifique. On comprend que la prise en compte de cet écart permet d'assurer une continuité des deux angles visibles dans le plan. La détermination de l'écart entre les repères inertiels est connue et de préférence effectuée conformément au document WO-A-2014/102261.

On notera que le positionnement dans un même plan des deux unités de mesure inertielle est avantageux car il permet de simplifier les calculs. En effet dans le cas contraire, il faudrait faire des corrections des plans de calage entre les unités de mesure inertielle (écart d'orientation et bras de levier) pour rendre les mesures homogènes entre les deux unités de mesure inertielle et pouvoir projeter les mesures de l'une des unités de mesure inertielle dans le repère de l'autre des unités de mesure inertielle.

Avantageusement, l'unité de commande 50 est également programmée pour surveiller la première unité de mesure inertielle 1 lorsque le plateau 30 est fixe en calculant une accélération à partir des mesures de la deuxième unité de mesure inertielle 2 et en vérifiant qu'elle est homogène avec l'accélération calculée à partir des mesures de la première unité de mesure inertielle 1. Si les mesures sont hétérogènes, l'unité de commande 50 émet une alerte par exemple à destination d'un conducteur du véhicule porteur.

Bien entendu, l'invention n'est pas limitée au mode de réalisation décrit mais englobe toute variante entrant dans le champ de l'invention telle que définie par les revendications.

En particulier, le dispositif peut avoir une structure différente de celle décrite.

L'axe de rotation Z pourrait ne pas être vertical.

Le mouvement du plateau pourrait être différent de celui décrit : le nombre de positions intermédiaire peut être différent de une ; ou le mouvement de 360° pourrait être continu ; ou l'amplitude du mouvement pourrait être différente de 360°.

La vitesse de rotation et les temps t1, t2 et le temps t pour réaliser le tour aller-retour peuvent être différents de ceux indiqués. On pourra par exemple avoir un temps t1 de 2 secondes.

En variante, si le véhicule est susceptible d'avoir des débattements importants par rapport à l'horizontale (ou plus généralement au plan P), la plateforme stabilisée 60 est une plateforme à cardan. A l'inverse, lorsque le véhicule est relativement stable par rapport au plan P, il est possible de fixer le bâti directement sur le véhicule sans passer par une plateforme stabilisée.

L'unité électronique de commande 50 peut avoir une structure différente de celle décrite et être par exemple fabriquée à partir de processeur, microcontrôleur ou FPGA.

## Revendications

1. Dispositif de mesure inertielle agencé pour être embarqué dans un véhicule porteur, comprenant : un bâti (40), un plateau (30) monté sur le bâti pour tourner autour d'un axe de rotation (Z) normal à une surface (32) du plateau (30), et une première unité de mesure inertielle (1) qui est montée sur ladite surface (32) du plateau (30) et qui est reliée à une unité électronique de commande (50) reliée à un moteur d'entraînement (31) en rotation du plateau (30) pour commander la rotation du plateau (30), la première unité de mesure inertielle (1) comprenant trois gyromètres (20x, 20y, 20z) et trois accéléromètres (10x, 10y, 10z) disposés selon les axes d'un premier repère de mesure (R1) ; **caractérisé en ce qu'**il comprend une deuxième unité de mesure inertielle (2), solidaire du bâti (40) , comprenant trois gyromètres et trois accéléromètres disposés selon les axes d'un deuxième repère de mesure (R2), et **en ce que** l'unité de commande (50) est agencée pour :
- depuis une position angulaire initiale fixe du plateau (30), faire périodiquement tourner le plateau (30) sur un tour avec un mouvement aller et un mouvement retour symétrique pour ramener le plateau (30) dans la position initiale fixe,
- calculer, sur une durée prédéterminée, une accélération du véhicule porteur à partir :
. des mesures accélérométriques et des mesures gyrométriques de la première unité de mesure inertielle (1) tant que le plateau (30) est fixe,
. des mesures accélérométriques et des mesures gyrométriques de la deuxième unité de mesure inertielle (2) tant que le plateau (30) est en mouvement,
- reconstituer un repère inertiel de chaque unité de mesure inertielle à partir des mesures accélérométriques et des mesures gyrométriques mesurées par ladite unité de mesure pendant la durée prédéterminée et comparer les deux repères inertiels pour déterminer un écart d'orientation entre eux et tenir compte de cet écart d'orientation dans le calcul de l'accélération lors du passage de l'utilisation des mesures gyrométriques de la première unité de mesure (1) à l'utilisation des mesures gyrométriques de la deuxième unité de mesure (2) et inversement.

2. Dispositif selon la revendication 1, dans lequel l'unité de commande (50) est agencée pour surveiller la première unité de mesure inertielle (1) lorsque le plateau (30) est fixe en calculant une accélération à partir des mesures de la deuxième unité de mesure inertielle (2) et en vérifiant qu'elle est homogène avec l'accélération calculée à partir des mesures de la première unité de mesure inertielle (1).

3. Dispositif selon la revendication 1 ou 2, dans lequel le support est une plateforme stabilisée (60, 60') pour maintenir ladite surface (32) du plateau (30) sensiblement dans un même plan (P) en autorisant un débattement angulaire du porteur d'environ 20 degrés par rapport audit plan (P).

4. Dispositif selon la revendication 3, dans lequel la plateforme stabilisée est une plateforme à cardan.

5. Dispositif selon l'une quelconque des revendications précédentes, dans lequel l'axe de rotation (Z) du plateau (30) est vertical.

6. Dispositif selon l'une quelconque des revendications précédentes, dans lequel la première centrale inertielle (1) et la deuxième centrale inertielle (2) sont positionnées sur un même plan (P) perpendiculaire à l'axe de rotation (Z).

7. Dispositif selon l'une quelconque des revendications précédentes, dans lequel l'unité de commande (50) est agencée pour commander le moteur (31) de telle manière que le mouvement aller et le mouvement retour comprennent un arrêt en au moins une position angulaire intermédiaire prédéfinie.

## Patentansprüche

1. Trägheitsmessvorrichtung, die ausgebildet ist, in einem Trägerfahrzeug mitgenommen zu werden, und umfasst: ein Gestell (40), eine Platte (30), die auf dem Gestell drehbar um eine Rotationsachse (Z) gelagert ist, die senkrecht zu einer Oberfläche (32) der Platte (30) ist, und eine erste Trägheitsmesseinheit (1), die auf der genannten Oberfläche (32) der Platte (30) angebracht und mit einer elektronischen Steuereinheit (50) verbunden ist, die mit einem Antriebsmotor (31) zum Drehantrieb der Platte (30) verbunden ist, um die Drehung der Platte (30) zu steuern, wobei die erste Trägheitsmesseinheit (1) drei Gyrometer (20x, 20y, 20z) und drei Beschleunigungsmesser (10x, 10y, 10z) umfasst, die gemäß den Achsen eines ersten Messbezugssystems (R1) angeordnet sind, **dadurch gekennzeichnet, dass** sie eine zweite Trägheitsmesseinheit (2) umfasst, die fest mit dem Gestell (40) verbunden ist und drei Gyrometer und drei Beschleunigungsmesser umfasst, die gemäß den Achsen eines zweiten Messbezugssystems (R2) angeordnet sind, und dass die Steuereinheit (50) ausgebildet ist, um
- ab einer ortsfesten initialen Winkelposition der Platte (30) die Platte (30) zu veranlassen, sich periodisch um eine Umdrehung mit symmetrischen Vor- und Rückbewegungen zu drehen, um die Platte (30) wieder in die ortsfeste initiale Position zu bringen,
- eine Beschleunigung des Trägerfahrzeugs über eine vorbestimmte Dauer zu berechnen anhand von:
. Beschleunigungsmessungen und gyrometrischen Messungen der ersten Trägheitsmesseinheit (1), solange die Platte (30) ortsfest ist,
• Beschleunigungsmessungen und gyrometrischen Messungen der zweiten Trägheitsmesseinheit (2), solange die Platte (30) in Bewegung ist,
- ein Trägheitsbezugssystem für jede Trägheitsmesseinheit anhand von Beschleunigungsmessungen und gyrometrischen Messungen, die von der genannten Messeinheit während der vorbestimmten Dauer gemessen werden, zu rekonstruieren und die beiden Trägheitsbezugsysteme zu vergleichen, um eine Ausrichtungsdifferenz zwischen diesen zu bestimmen und diese Ausrichtungsdifferenz bei der Berechnung der Beschleunigung beim Übergang der Nutzung der gyrometrischen Messungen der ersten Messeinheit (1) zur Nutzung der gyrometrischen Messungen der zweiten Messeinheit (2) und umgekehrt zu berücksichtigen.

2. Vorrichtung nach Anspruch 1, bei der die Steuereinheit (50) ausgebildet ist, die erste Trägheitsmesseinheit (1) zu überwachen, wenn die Platte (30) ortsfest ist, indem eine Beschleunigung anhand der Messungen der zweiten Trägheitsmesseinheit (2) berechnet wird und indem verifiziert wird, dass sie homogen mit der Beschleunigung ist, die anhand der Messungen der ersten Trägheitsmesseinheit (1) berechnet wird.

3. Vorrichtung nach Anspruch 1 oder 2, bei der der Träger eine stabilisierte Plattform (60, 60') ist, um die genannte Oberfläche (32) der Platte (30) im Wesentlichen in einer selben Ebene (P) zu halten, während ein Winkelausschlag des Trägers von ungefähr 20 Grad in Bezug auf die genannte Ebene (P) gestattet wird.

4. Vorrichtung nach Anspruch 3, bei der die stabilisierte Plattform eine Kardanplattform ist.

5. Vorrichtung nach einem der vorhergehenden Ansprüche, bei der die Rotationsachse (Z) der Platte (30) vertikal ist.

6. Vorrichtung nach einem der vorhergehenden Ansprüche, bei der die erste Trägheitsmesseinheit (1) und die zweite Trägheitsmesseinheit (2) auf einer selben Ebene (P) positioniert sind, die senkrecht zur Rotationsachse (Z) ist.

7. Vorrichtung nach einem der vorhergehenden Ansprüche, bei der die Steuereinheit (50) ausgebildet ist, den Motor (31) derart zu steuern, dass die Vorwärtsbewegung und die Rückwärtsbewegung einen Halt in mindestens einer vordefinierten intermediären Winkelstellung umfassen.

## Claims

1. Inertial measurement apparatus arranged to be carried by a carrier vehicle, the apparatus comprising: a chassis (40), a turntable (30) mounted on the chassis to turn about an axis of rotation (Z) normal to a surface (32) of the turntable (30), and a first inertial measurement unit (1) that is mounted on said surface (32) of the turntable (30) and that is connected to an electronic control unit (50) connected to a motor (31) for driving the turntable (30) to control turning of the turntable (30), the first inertial measurement unit (1) comprising three rate gyros (20x, 20y, 20z) and three accelerometers (10x, 10y, 10z) arranged on the axes of a first measurement reference frame (R1); the apparatus being **characterized in that** it comprises a second inertial measurement unit (2) secured to the chassis (40) and comprising three rate gyros and three accelerometers arranged on the axes of a second measurement reference frame (R2), and **in that** the control unit (50) is arranged:
• from a fixed initial angular position of the turntable (30), to cause the turntable (30) to turn periodically through one revolution with symmetrical go and return movements in order to return the turntable (30) to the fixed initial position;
• over a predetermined duration, to calculate the acceleration of the carrier vehicle from:
· accelerometer and gyro measurements of the first inertial measurement unit (1) while the turntable (30) is stationary; and
· accelerometer and gyro measurements of the second inertial measurement unit (2) while the turntable (30) is moving; and
• to reconstitute an inertial reference frame for each inertial measurement unit from the accelerometer measurements and the gyro measurements measured by said measurement unit during the predetermined duration and to compare the two inertial reference frames in order to determine an orientation difference between them and to take account of this orientation difference when calculating the acceleration on switching from using gyro measurements of the first measurement unit (1) to using gyro measurements of the second measurement unit (2), and vice versa.

2. Apparatus according to claim 1, wherein the control unit (50) is also arranged to monitor the first inertial measurement unit (1) when the turntable (30) is stationary by calculating acceleration from the measurements of the second inertial measurement unit (2) and by verifying that it matches the acceleration calculated from the measurements of the first inertial measurement unit (1).

3. Apparatus according to claim 1 or claim 2, wherein the support is a stabilized platform (60, 60') for keeping said surface (32) of the turntable (30) substantially in the same plane (P) while accommodating angular movements of the carrier through about 20° relative to said plane (P) .

4. Apparatus according to claim 3, wherein the stabilized platform is a gimbal platform.

5. Apparatus according to any preceding claim, wherein the axis of rotation (Z) of the turntable (30) is vertical.

6. Apparatus according to any preceding claim, wherein the first inertial unit (1) and the second inertial unit (2) are positioned on the same plane (P) that is perpendicular to the axis of rotation (Z).

7. Apparatus according to any preceding claim, wherein the control unit (50) is arranged to control the motor (31) in such a manner that the go movement and the return movement include a stop at at least one predefined intermediate angular position.
